# EUROPÄISCHE PATENTSCHRIFT

(11) **EP 2 359 382 B1**
(45) Veröffentlichungstag und Bekanntmachung des Hinweises auf die Patenterteilung: **14.08.2013**
(21) Anmeldenummer: 09743852.7
(22) Anmeldetag: 08.10.2009
(51) Int. Cl.: H01J 37/32

(54) **Zündvorrichtung für ARC-Quellen**
Ignition apparatus for ARC sources
Dispositif d'allumage pour sources d'ARC

(30) Priorität: 12.11.2008 DE 102008057020
(43) Veröffentlichungstag der Anmeldung: 24.08.2011
(73) Patentinhaber: Oerlikon Trading AG, Trübbach, 9477 Trübbach (CH)
(72) Erfinder: KRASSNITZER, Siegfried, A-6800 Feldkirch (AT); GSTOEHL, Oliver, FL-9496 Balzers (LI); HAGMANN, Juerg, CH-9468 Sax (CH)
(74) Vertreter: Kempkens, Anke
(86) Internationale Anmeldenummer: PCT/EP2009/007227
(87) Internationale Veröffentlichungsnummer: WO 2010/054726

(56) Entgegenhaltungen:
- EP-A- 1 267 384
- WO-A-2008/125397
- DE-A1- 19 522 331
- DE-T2- 69 006 593
- US-A1- 2004 134 771
- US-B1- 6 413 387

## Beschreibung

Die vorliegende Erfindung betrifft eine Zündeinrichtung zum Zünden einer Hochstromentladung eines elektrischen Lichtbogenverdampfers in einer Vakuumbeschichtungsanlage gemäss dem Oberbegriff des Anspruchs 1.

Ein wie oben erwähnter Lichtbogenverdampfer, auch Arc- oder Funkenquelle genannt, wird zur Behandlung von Werkstücken im Hochvakuum, insbesondere zum Plasmaätzen und/oder zum Beschichten verwendet.

### Stand der Technik

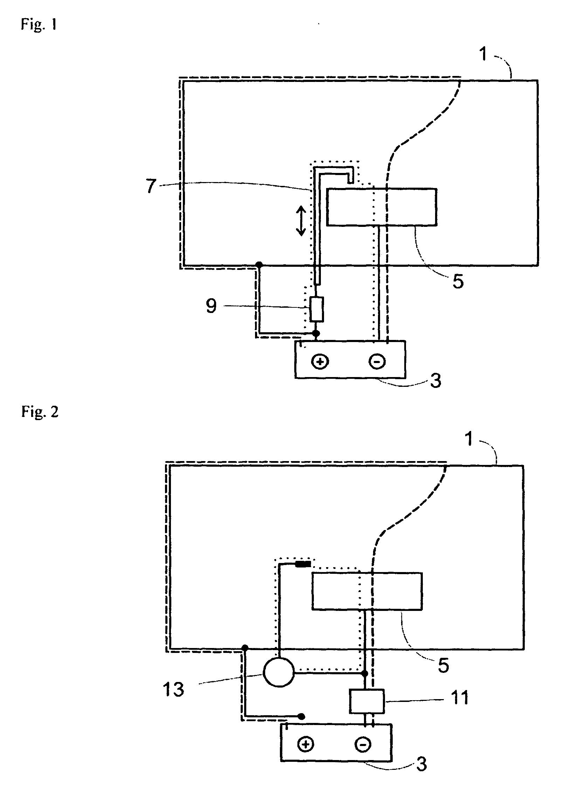

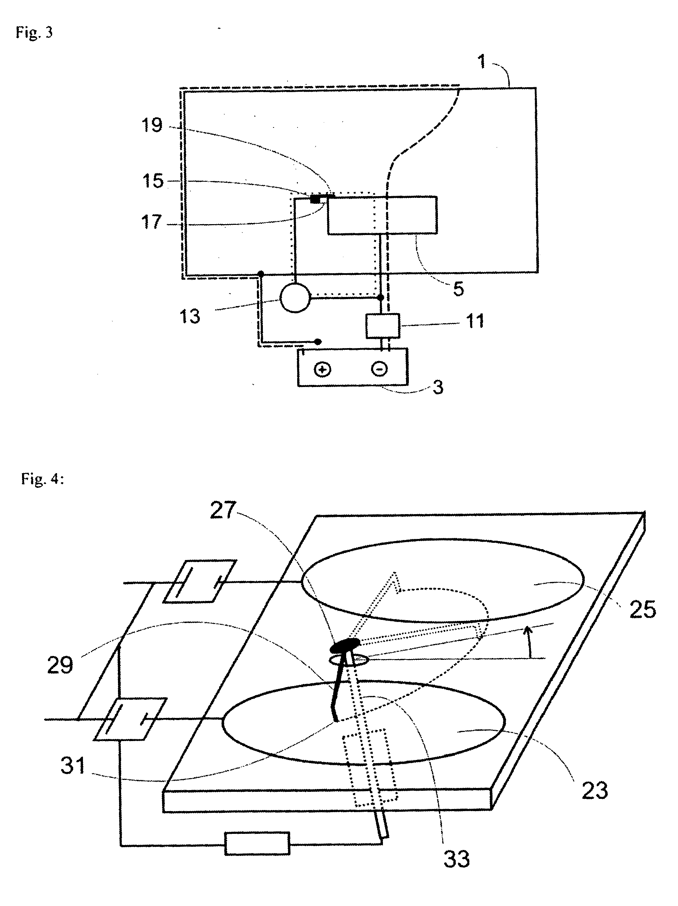

Zündvorrichtungen von ARC - Verdampfungsquellen können im Wesentlichen in 3 Gruppen eingeteilt werden:
a.) mechanisches Schliessen und Öffnen eines Kontakts zwischen Kathode und Anode, wobei der Strom über einen Vorwiderstand auf typischerweise ca. 5A limitiert wird. Ein solcher Mechanismus ist in Figur 1 dargestellt. Dabei wird durch eine Hubbewegung die Fingerspitze eines Triggerfingers 7 in Berührung mit der Kathode 5 gebracht und dadurch der Stromkreis geschlossen. In der Figur 1 ist der Stromkreis gepunktelt eingezeichnet. Der Generator 3 befindet sich im Leerlauf bei einer Leerlaufspannung von typischer Weise 60 - 120V. Der Strom über den Triggerfinger 7 wird durch den Widerstand 9 auf eine Grössenordnung von ca. 5 A beschränkt. Durch das Lösen des Stromkreises mittels z.B. einer weiteren Hubbewegung, bei der die Fingerspitze von der Kathode entfernt wird, wird ein Funke an der Kathodenoberfläche erzeugt. Dies ist das Initialplasma welches durch den extrem dynamischen Generator 3 weitergetrieben wird. Der dementsprechende Stromkreis ist gestrichelt gezeichnet.
b.) Zünden der ARC Entladung durch einen elektrischen Überschlag
   Dies wird beispielsweise mittels einer Vorrichtung gemäss Figur 2 erreicht. Hierbei erzeugt ein mittels eines Hochspannungspulses eines Pulsgenerators 13 erzeugter elektrischer Überschlag einen Anfangsfunken auf dem Target 5. Der der durch den Pulsgenerator getriebene Stromkreis ist gepunktelt gezeichnet. Der Anfangsfunken wird durch das ARC-Power-Supply 3 weitergetrieben. Der entsprechende Stromkreis ist gestrichelt gezeichnet. Die Ausgangsstufe des ARC-Power-Supply muss in der Regel durch einen Schaltkreis 11 vor dem Hochspannungsimpuls geschützt werden.
c.) Zünden durch eine elektrisch leitende Brücke
   Dies wird beispielsweise mittels einer Vorrichtung gemäss Figur 3 erreicht. Während dem Betrieb der ARC -Quelle wird ein Isolator 17 welcher zwischen Anode und Kathode 5 liegt beschichtet. Im Falle der Beschichtung einer leitenden Schicht entsteht einen Widerstandsbrücke 15 von der Kathode zur Anode. Durch einen der ARC-Supply überlagerten Hochspannungspuls (bis ca. 500V) wird über diesen Widerstand ein Strom von der Kathode zur Anode geleitet, welcher die leitende Schicht 19 lokal zum Aufschmelzen bringt. Die ARC -Entladung wird dadurch gezündet. Diese leitende Schicht wird im Betrieb der Quelle immer erneuert. Bei jungfräulicher Quelle wird meist durch eine aufgepinselte Silberschicht der Vorgang initialisiert. Diese Methode funktioniert allerdings nicht beim verdampfen isolierender Schichten.

Bisher wurden Methoden beschrieben, die es lediglich gestatten, den Funken an einer Kathode bzw. einem Target zu Zünden. Im Stand der Technik ist eine Vorrichtung bekannt, die beim Triggerfinger zusätzlich zur Hubbewegung auch noch eine Rotationsbewegung vorsieht. Mittels der Rotationsbewegung kann der Triggerfinger von einem ersten Target auf mindestens ein weiteres Target umgeschwenkt werden.

Eine solche Vorrichtung ist in US6998034 offenbart. Hier wird ein drehbarer und verschiebbarer Triggerfinger zur Zündung einer oder mehrerer Arc-Quellen offenbart. Bei der dort offenbarten Anordnung wird durch eine Dreh- und Hubbewegung von Target 1 auf Target N gewechselt (im Beispiel bis zu vier Targets). Von Nachteil ist allerdings dass hierbei ein aufwändiges Antriebskonzept benötigt wird.

Es wäre daher wünschenswert eine für mehrere Targets verwendbare Zündvorrichtung auf der Basis von mechanischem Öffnen und Schliessen eines Kontaktes welches ohne ein aufwändiges Antriebskonzept auskommt, zur Verfügung zu haben.

Es ist daher Aufgabe der vorliegenden Erfindung ist eine Zündvorrichtung anzugeben, welche in die Gruppe des mechanischen Öffnens und Schliessens eines Kontaktes eingeordnet werden kann, die für mehrere Targets ausgelegt ist und/oder bei der das zur Zündung verwendeten Kontaktteil während des Beschichtungsprozesses vor einer Beschichtung geschützt ist. Hierzu wird ein Triggerfinger derart beweglich vorgesehen, dass eine Bewegung der Fingerspitze im Wesentlichen lediglich auf einer Zwangsbahn ermöglicht ist, wobei die Zwangsbahn jedes der zu zündenden Targets an mindestens einem Punkt tangiert und/oder schneidet. Die Fingerspitze ist in diesem Fall das zur Zündung verwendete Kontaktteil. Erfindungsgemäss kann diese nach der Zündung entlang der Zwangsbahn auf eine Parkposition fernab vom Wirkungsraum des Target gefahren werden, so dass sie während dem Beschichtungsprozess im Wesentlichen nicht beschichtet wird. Da die Fingerspitze nicht beschichtet wird, können längere Standzeiten erreicht werden. Ausserdem wird die Zündzuverlässigkeit signifikant erhöht. Die trifft besonders für Prozesse bei denen isolierender Schichten und insbesondere Oxidschichten beschichtet werden.

In einer ersten Ausführungsform wird der Triggerfinger an einer Drehachse montiert die Drehachse zwischen den Targets geneigt angeordnet, so dass sich bei Rotation der Drehachse die Fingerspitze entlang eines Kreissegmentes bewegt, wobei die Ebene des Kreissegementes die Ebene schneidet, in der zwei Targets angeordnet sind.

In einer zweiten Ausführungsform wird der Triggerfinger linear entlang einer Kulisse geführt. Die Kulisse bewirkt das Absenken der Fingerspitze auf dem jeweiligen Target, sowie das Abheben der Fingersspitze vom Target.

Eine dritte Ausführungsform der vorliegenden Erfindung stellt eine Kombination der ersten Ausführungsform und der zweiten Ausführungsform dar. D.h. der Finger ist wiederum an einer Drehachse montiert. Er ist allerdings relativ zu dieser Drehachse in der Weise beweglich montiert, dass er um die Achse senkrecht zur Drehachse und Senkrecht zur Achse des Fingers rotiert werden kann. Diese Rotation ist allerdings wiederum eingeschränkt durch eine Kulisse. Wird die Drehachse gedreht, so bewegt sich die Fingerspitze entsprechend der vorgegebenen Rotation und entsprechend der Vorgaben durch die Kulisse.

Die Erfindung wird nun anhand der Figuren und mit Hilfe verschiedener Ausführungsformen beispielhaft erklärt.

Figur 4 zeigt eine erste Ausführungsform der vorliegenden Erfindung mit einem Teil einer Vakuumkammer 21 an dem zwei Targets 23, 25 im Wesentlichen in einer ersten Ebene vorgesehen sind. Ausserdem ist eine Zündvorrichtung 27 mit Triggerfinger 29 und Fingerspitze 31. Die Zündvorrichtung umfasst ausserdem eine Welle 33 an der der Triggerfinger 29 fix angeordnet ist. Erfindungsgemäss bildet die Achse der Welle 33 mit der Normalen auf der ersten Ebene einen Winkel ungleich null. so dass der Kreisbogen, auf dem sich die Fingerspitze 31 bei Drehung der Welle 33 bewegt in einer Ebene liegt, welche die durch die Targets definierte Ebene im Bereich der Targets schneidet. Damit kann die Fingerspitze 31 des Triggerfingers 29 durch eine einzige Drehbewegung von der einen Targetoberfläche 23 zur anderen Targetoberfläche 25 reversibel bewegt werden.

Durch die schräggestellte Welle 33 kann also der Triggerrfinger allein durch eine Drehbewegung auf der Targetoberfläche einen Kontakt herstellen. In der gezeigten Ausführungsform ist die Zündvorrichtung in seiner Funktion symmetrisch, und daher für 2 nebeneinander angeordnete Arc-Quellen (Targets) zu verwenden. Besonders vorteilhaft ist, dass der Triggerfinger 29 nach erfolgter Zündung ins Zenit des Kreisbogens in eine Parkposition ausserhalb der Targetbereiche, gedreht werden kann. Damit wird während dem Beschichtungsbetrieb der Arc Quellen der Triggerfinger nur geringfügig verschmutzt, was eine lange Standzeit ohne Reinigung ermöglicht. Ein weiterer Vorteil dieser Ausführungsform ist, dass die Triggerpunkte, d.h. die Punkte an denen die Fingerspitze 31 die Oberflächen der Targets 23, 25 berühren automatisch durch Ausschwenken des Triggerfingers erreicht wird. Bei Veränderung der Targetoberflächen, insbesondere durch Targeterosion aufgrund des Beschichtungsprozesses ist damit keine Justage der Abstände oder der Hubbewegung notwendig ist.

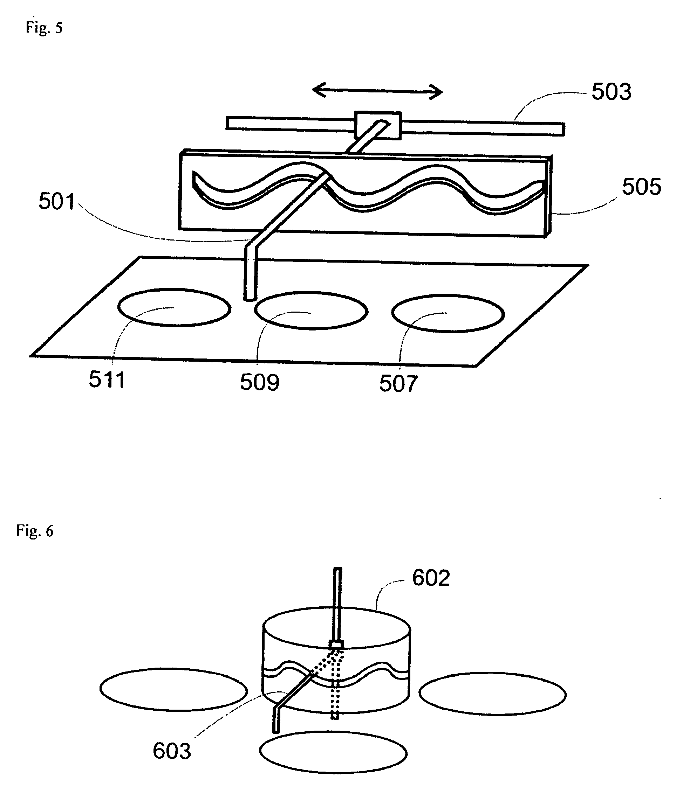

Figur 5 zeigt eine zweite Ausführungsform der vorliegenden Erfindung. Dabei ist ein Triggerfinger 501 an einer Schiene 503 beweglich derart montiert, dass er entlang der Schiene bewegt werden kann. Ausserdem könnte kann der Triggerfinger um die Schiene 503 rotiert werden, wäre da nicht die Kulisse 505 die den Triggerfinger sich auf einer Zwangsbahn bewegen lässt wenn er entlang der Schiene 503 verschoben wird. Gezeigt in der Figur 5 sind auch 3 Tragets 507, 509, 511. Die Kulisse 505 ist derart ausgestaltet, dass bei Verschiebung des Triggerfingers 501 entlang der Schiene 503 die Bahn der Fingerspitze jeweils die Oberfläche der Targets berührt. Dem Fachmann leuchtet ein, dass sich diese Ausführungsform auf eine beliebige Zahl von Targets erweitern lässt. Es ist wiederum vorteilhaft, dass der Triggerfinger 501 nach erfolgter Zündung in eine Parkposition ausserhalb der Targetbereiche verschoben werden kann.

Figur 6 zeigt eine weitere Ausführungsform der vorliegenden Erfindung, die in gewisser Weise eine Kombination aus der ersten und der zweiten Ausführungsform darstellt. Die in der zweiten Ausführungsform erwähnte Kulisse ist dabei zu einer zylinderförmigen Manschette 602 umgeformt. Der Triggerfinger 603 kann um eine Achse parallel zur Zylinderachse und im wesentlichen im Zylindermittelpunkt rotiert werden. Der Triggerfinger wird durch die Kulisse der Manschette auf einer Zwangsbahn geführt.

Die Erfindung wurde anhand Beispielen mit mehreren Targets beschrieben. Es bleibt allerdings anzumerken dass der Aspekt, den Zündfinger in eine vor Beschichtung geschützte Parkposition zu fahren auch vorteilhaft eingesetzt werden kann, wenn es darum geht, mit dem Zündfinger lediglich ein Target zünden zu können.

### Bezugszeichenliste

- 1: Vakuumkammer
- 3: Generator
- 5: Kathode bzw. Target
- 7: Triggerfinger
- 9: Widerstand
- 11: Schutzschaltkreis
- 13: Pulsgenerator
- 15: Widerstandsbrücke
- 17: Isolator
- 19: Leitende Schicht
- 21: Teil der Vakuumkammer
- 23: Target
- 25: Target
- 27: Zündvorrichtung
- 29: Triggerfinger
- 31: Fingerspitze
- 33: Welle
- 501: Triggerfinger
- 503: Schiene
- 505: Kulisse
- 507: Target
- 509: Target
- 511: Target
- 602: Manschette
- 603: Triggerfinger

## Patentansprüche

1. ARC-Quelle mit einem ersten Target (23) und einem zweiten Target (25), wobei erstes und zweites Target im Wesentlichen in einer ersten Ebene liegen, und eine Zündvorrichtung (27) zum Zünden eines Funkens am ersten Target und am zweiten Target vorgesehen ist, wobei die Zündvorrichtung einen beweglich montierten Triggerfinger (29, 501, 603) umfasst dergestalt, dass Mittel zur Bewegung der Fingerspitze (31) des Triggerfingers zur Oberfläche des ersten Targets und zur Oberfläche des zweiten Targets vorgesehen sind, wobei die Mittel zur Ausführung der Bewegung einen Antrieb aus der Gruppe Linearantrieb oder Drehantrieb umfassen, **dadurch gekennzeichnet, dass** der Antrieb mit Führungsmitteln derartig zusammenwirkt, dass sich die Fingerspitze im Antriebsfall auf einer Zwangsbahn bewegt, welche beide Targets tangiert und/oder schneidet.

2. Arc-Quelle gemäss Anspruch 1, **dadurch gekennzeichnet dass** die Mittel zur Ausführung der Bewegung eine Welle (33) Umfassen, deren Achse gegen die Normale auf die erste Ebene verkippt ist und der Triggerfinger (29) an der Welle starr angeordnet ist und der Antrieb ein Drehantrieb ist, welcher die Welle zu drehen vermag und die Zwangsbahn in einer jeweils auf dem ersten und dem zweiten Target endenden Kreisbogen besteht.

3. Arc-Quelle gemäss Anspruch 1, **dadurch gekennzeichnet dass** die Mittel zur Ausführung der Bewegung eine Welle (33) umfassen und der Triggerfinger (603) an der Welle angeordnet ist dergestalt beweglich, dass die Höhe der Fingerspitze (31), definiert durch die senkrechte Projektion der Fingerspitze auf die Welle, variiabel ist und die Führungsmittel als radial von der Welle beabstandete Kulisse (602) ausgebildet sind wobei der Antrieb ein Drehantrieb ist.

4. Arc-Quelle gemäss Anspruch 1, **dadurch gekennzeichnet, dass** die Mittel zur Ausführung der Bewegung eine Schiene (503) umfassen an der der Triggerfinger (501) linear verschiebbar montiert ist und die Führungsmittel als Kulisse (505) ausgebildet sind.

5. Arc-Quelle nach Anspruch 4, dadruch gekennzeichnet, dass der Antrieb ein Linearantrieb ist.

6. Arc-Quelle nach Anspruch 4, **dadurch gekennzeichnet dass** der Antrieb ein Drehantrieb ist mit dem die Schiene gedreht werden kann.

7. Vorrichtung zum behandeln von Werkstücken im Vakuum mit einer Arc-Quelle gemäss einem der vorangehenden Ansprüche.

8. Vorrichtung nach Anspruch 7 die eine Beschichtungsanlage ist

9. Vorrichtung nach Anspruch 8, die eine Plasmaätzanlage ist.

## Claims

1. Arc source with a first target (23) and a second target (25), wherein first and second targets lie substantially in a first plane, and an ignition device (27) is provided for igniting a spark at the first target and at the second target, wherein the ignition device comprises a trigger finger (29, 501, 01) which is mounted movably such that means are provided for moving the fingertip (31) of the trigger finger towards the surface of the first target and towards the surface of the second target, wherein the means for executing the movement comprise a drive from the group of linear drives or rotary drives, **characterised in that** the drive cooperates with guide means such that when driven, the fingertip moves on a forced path which touches and/or intersects both targets.

2. Arc source according to claim 1, **characterised in that** the means for executing the movement comprise a shaft (33), the axis of which is tilted in relation to the normal of the first plane, and the trigger finger (29) is arranged rigidly on the shaft and the drive is a rotary drive which enables the shaft to rotate, and the forced path consists of a circle arc ending at both the first and the second targets.

3. Arc source according to claim 1, **characterised in that** the means for executing the movement comprise a shaft (33) and the trigger finger (603) is arranged movably on the shaft such that the height of the fingertip (31), defined by the vertical projection of the fingertip to the shaft, is variable and the guide means are formed as a sliding block guide (602) spaced radially from the shaft, wherein the drive is a rotary drive.

4. Arc source according to claim 1, **characterised in that** the means for executing the movement comprise a rail (503) on which the trigger finger (501) is mounted in a linearly movable manner, and the guide means are formed as a sliding block guide (505).

5. Arc source according to claim 4, **characterised in that** the drive is a linear drive.

6. Arc source according to claim 4, **characterised in that** the drive is a rotary drive with which the rail can be rotated.

7. Device for treating workpieces in a vacuum with an arc source according to any of the preceding claims.

8. Device according to claim 7 which is a coating plant.

9. Device according to claim 8 which is a plasma etching plant.

## Revendications

1. Source d'arc avec une première cible (23) et une deuxième cible (25), les première et deuxième cibles se trouvant sensiblement dans un premier plan, et un dispositif d'allumage (27) servant à allumer une étincelle sur la première cible et la deuxième cible étant prévu, le dispositif d'allumage comprenant un doigt déclencheur (29, 501, 603) monté mobile, en sorte que des moyens de déplacement de l'extrémité (31) du doigt déclencheur jusqu'à la surface de la première cible et jusqu'à la surface de la deuxième cible sont prévus, les moyens d'exécution du déplacement comprenant un entraînement du groupe entraînement linéaire ou du groupe entraînement rotatif, **caractérisé en ce que** l'entraînement interagit avec les éléments de guidage de façon à ce que l'extrémité du doigt se déplace, en cas d'entraînement, sur une trajectoire forcée, qui est tangente aux deux cibles et/ou les coupe.

2. Source d'arc selon la revendication 1, **caractérisée en ce que** les moyens d'exécution du déplacement comprennent un arbre (33) dont l'axe est basculé contre la perpendiculaire sur le premier plan, et **en ce que** le doigt déclencheur (29) est monté fixe à l'arbre, et **en ce que** l'entraînement est un entraînement rotatif qui peut faire tourner l'arbre, et **en ce que** la trajectoire forcée est constituée d'arcs de cercle finissant respectivement sur la première et la deuxième cible.

3. Source d'arc selon la revendication 1, **caractérisée en ce que** les moyens d'exécution du déplacement comprennent un arbre (33), et **en ce que** le doigt déclencheur (603) est monté mobile sur l'arbre, en sorte que la hauteur de l'extrémité (31) du doigt, définie par la projection verticale de l'extrémité du doigt sur l'arbre, est variable, et **en ce que** les éléments de guidage sont conçus comme une coulisse (602) espacée de l'arbre radialement, l'entraînement étant un entraînement rotatif.

4. Source d'arc selon la revendication 1, **caractérisée en ce que** les moyens d'exécution du déplacement comprennent un rail (503) auquel le doigt déclencheur (501) est monté de manière à pouvoir se déplacer linéairement, et **en ce que** les éléments de guidage sont conçus comme une coulisse (505).

5. Source d'arc selon la revendication 4, **caractérisée en ce que** l'entraînement est un entraînement linéaire.

6. Source d'arc selon la revendication 4, **caractérisée en ce que** l'entraînement est un entraînement rotatif au moyen duquel le rail peut tourner.

7. Dispositif de traitement de pièces à usiner dans le vide à l'aide d'une source d'arc selon l'une quelconque des revendications précédentes.

8. Dispositif selon la revendication 7, qui est une installation de revêtement.

9. Dispositif selon la revendication 8, qui est un dispositif de gravure au plasma.
